(19) Europäisches Patentamt
European Patent Office
Office européen des brevets

(11) Publication number : 0 510 646 B1

# (12) EUROPEAN PATENT SPECIFICATION

(45) Date of publication of patent specification : **26.07.95 Bulletin 95/30**

(51) Int. Cl.$^6$ : **G03F 7/027,** G03F 7/075

(21) Application number : **92106962.1**

(22) Date of filing : **23.04.92**

## (54) Presensitized plates for use in making lithographic printing plates not requiring dampening with water.

(30) Priority : **25.04.91 JP 95581/91**

(43) Date of publication of application : **28.10.92 Bulletin 92/44**

(45) Publication of the grant of the patent : **26.07.95 Bulletin 95/30**

(84) Designated Contracting States : **DE GB**

(56) References cited :
**EP-A- 0 386 777**
**EP-A- 0 490 368**

(73) Proprietor : **FUJI PHOTO FILM CO., LTD.
No. 210, Nakanuma
Minami-Ashigara-shi
Kanagawa-ken (JP)**

(72) Inventor : **Hirano, Tsumoru, c/o Fuji Photo Film Co., Ltd.
4000, Kawashiri,
Yoshida-cho
Haibara-gun, Shizuoka-ken (JP)**
Inventor : **Urabe, Yoshihiko, c/o Fuji Photo Film Co., Ltd.
4000, Kawashiri,
Yoshida-cho
Haibara-gun, Shizuoka-ken (JP)**
Inventor : **Higashi, Tatsuji, c/o Fuji Photo Film Co., Ltd.
4000, Kawashiri,
Yoshida-cho
Haibara-gun, Shizuoka-ken (JP)**

(74) Representative : **Patentanwälte Grünecker, Kinkeldey, Stockmair & Partner
Maximilianstrasse 58
D-80538 München (DE)**

EP 0 510 646 B1

Note : Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

### BACKGROUND OF THE INVENTION

1. Field of the Invention

The present invention relates to a presensitized plate for use in making lithographic printing plates not requiring dampening with water, more particularly to such a presensitized plate which comprises a substrate provided thereon with a light-sensitive layer and an ink-repellent layer in that order, and to a method for preparing a lithographic printing plate not requiring dampening with water from the presensitized plate.

2. Prior Art

There have been proposed various kinds of presensitized plates for use in making lithographic printing plates not requiring dampening with water (hereinafter referred to as "dry PS plates") in order to carry out lithographic printing operations without dampening water. Among them, those plates comprising a substrate coated with a light-sensitive layer and an ink-repellent layer in that order show quite excellent properties, and examples of such plates include those comprising an ink-repellent layer of silicone rubber such as disclosed in Japanese Patent Publication for Opposition Purposes (hereinafter referred to as "J.P. KOKOKU") Nos. Sho 54-26923 (U.S. Pat. No. 3,894,873), Sho 55-22781 (Brit. Pat. No. 1,419,643), Sho 56-23150 and Japanese Unexamined Patent Publication (hereinafter referred to as "J.P. KOKAI") No. Hei 2-236550 and those comprising an ink-repellent layer of fluorine resin such as disclosed in J.P. KOKAI Nos. Sho 58-215411 and Hei 2-103047.

As the light-sensitive layer of the positive-working presensitized plate for use in making a lithographic printing plate (hereinafter referred to as a "PS plate"), there is generally utilized a photopolymerizable light-sensitive composition which is curable by light exposure. In the image production process of the PS plate having the foregoing layer structure, the non-image areas are produced by curing the light-sensitive composition by light exposure and by causing photoadhesion at the interface between the ink-repellent layer and the light-sensitive layer to ensure firm adhesion between the two layers and to avoid the penetration of the developer into the photosensitive layer and hence the dissolution of the light-sensitive composition. On the other, the image areas are produced by partially dissolving the uncured light-sensitive resin layer and physically removing the ink-repellent layer.

In forming the image areas, therefore, the ink-repellent layer of the unexposed areas should be removed completely, and an important factor in achieving complete removal of the ink-repellent layer is the adhesion between the ink-repellent layer and the light-sensitive layer during the development.

Methods for developing these dry PS plates are disclosed in, for instance, J.P. KOKOKU No. Sho 56-23150, J.P. KOKAI Nos. Sho 57-13448, Sho 59-146054 and Sho 63-52145. However, the developers used in these methods comprise an organic solvent as a main component, and therefore such developers are rather expensive and have to be handled with special care because of their inflammability. For overcoming these problems, J.P. KOKAI No. Hei 1-59644 proposes a developer mainly composed of water. However, this developer has a complex composition, i.e., it contains an organic solvent which has low water-solubility and is solubilized with a surfactant, and thus it has a drawback in that its developing property is easily changed even by small variation in the composition. Thus, in order to provide a developer mainly composed of water and having a stable developing property unaffected by small variations in composition, it is necessary to stably solubilize the developer components such as organic solvent in water. In this respect, the developer is preferably selected from water and aqueous solutions of water-soluble organic solvents. However, the conventional dry PS plates such as disclosed in J.P. KOKOKU No. Sho 54-26923, J.P. KOKAI Nos. Sho 50-50102 and Hei 2-236550 cannot provide sufficient images by development with water or an aqueous solution of water-soluble organic solvents.

### SUMMARY OF THE INVENTION

Accordingly, an object of the present invention is to provide a dry PS plate which is developable with a developer composed of water or mainly water, shows excellent developability of the image areas and can provide a lithographic printing plate not requiring dampening with water with excellent tone-reproducibility.

Another object of the present invention is to provide a method for preparing lithographic printing plates not requiring dampening with water using a developer which is inexpensive and safe and shows stable developing property.

The inventors of the present invention have found that the objects can be attained by a dry PS plate whose

light-sensitive layer contains at least one water-soluble compound and at least one water-insoluble polymer compound which compounds cause phase separation in the light-sensitive layer to form a layer rich in the water-soluble compound contiguous to the interface of the light-sensitive layer and the ink-repellent layer.

Therefore, according to one aspect of the invention, there is provided a dry PS plate which comprises a substrate provided thereon with a photopolymerizable light-sensitive layer and an ink-repellent layer in that order, wherein the light-sensitive layer contains at least one water-soluble compound and at least one water-insoluble polymer compound which compounds cause phase separation in the light-sensitive layer to form a layer rich in the water-soluble compound contiguous to the interface of the light-sensitive layer and the ink-repellent layer.

According to another aspect of the invention, there is also provided a method for preparing a lithographic printing plate not requiring dampening with water which comprises imagewise exposing the dry PS plate of the invention to actinic light and removing the ink-repellent layer of the non-image areas while or after immersing the plate in water or an aqueous solution of water-soluble organic solvents mainly composed of water.

In the dry PS plate of the present invention, the water-soluble compound and the water-insoluble compounds contained in the light-sensitive layer cause phase separation so that a layer rich in the water-soluble compound (water-soluble-compound-rich layer) is formed contiguous to the interface of the light-sensitive layer and the ink-repellent layer. Therefore, the ink-repellent layers of the unexposed areas are easily removed with a developer composed of water or an aqueous solution of water-soluble organic solvents containing water as the main component to provide a lithographic printing plate with excellent tone-reproducibility. Thus the foregoing objects are achieved.

## DESCRIPTION OF THE PREFERRED EMBODIMENTS

The preferred embodiments of the dry PS plate according to the present invention will hereunder be described in more detail.

The photopolymerizable light-sensitive layer used in the present invention comprises a monomer having at least one photopolymerizable ethylenically unsaturated double bond, an organic water-insoluble polymeric compound and a photopolymerization initiator. The light-sensitive layer further comprises at least one water-soluble compound which may serve as the monomer when it has at least one polymerizable ethylenically unsaturated double bond. The one or more water-soluble compounds exhibit a certain level of compatibility with the water-insoluble polymer compound, but when contained in the light-sensitive layer of the dry PS plate of the present invention, they cause phase separation from the water-insoluble polymer compounds to form a concentrated layer thereof contiguous to the interface of the light-sensitive layer and the ink-repellent layer.

The water-soluble compounds need not necessarily contain polymerizable ethylenically unsaturated groups. However, from the viewpoint of the plate-making properties of the dry PS plate such as sensitivity and tone-reproducibility, they preferably have the polymerizable ethylenically unsaturated groups and more preferably have at least two of the polymerizable ethylenically unsaturated groups in the molecule. Specific examples of the water-soluble compounds which are usable in the present invention are listed below, but they are not limited to these compounds.

$HO-(CH_2CH_2O)_n-H$ (Mw: About 400, 600, 1000, 1500 or 4000)

$HO-(CH_2CH(CH_3)O)_n-H$ (Mw: About 500, 1000 or 2000)

$HO-(CH_2CH_2O)_n-(CH_2CH(CH_3)O)_m-H$ (Mn: About 500, 1000 or 2000)

$CH_2=C(CH_3)COO(CH_2CH_2O)_n-CH_3$ (n = 9, 14 or 23)

$CH_2=CHCOO(CH_2CH_2O)_n-CH_3$ (n = 9, 14 or 23)

$CH_2=CHCOOCH_2CH_2OCOCH_2CH_2COOH$

$CH_2=CHCOO(CH_2CH_2O)_n-COCH=CH_2$ (n = 9, 14 or 23)

$CH_2=C(CH_3)COO(CH_2CH_2O)_n-COC(CH_3)=CH_2$ (n = 9, 14 or 23)

$CH_2=CHCOO(CH_2CH(CH_3)O)_n-COCH=CH_2$ (n = 18 or 23)

$CH_2=CHCOO(CH_2CH_2O)_n-(CH_2CH(CH_3)O)_m-COCH=CH_2$ (m + n = 18, 25 or 30)

$CH_2=C(CH_3)COO(CH_2CH_2O)_n-COCH=CH_2$ (n = 18, 28 or 36)

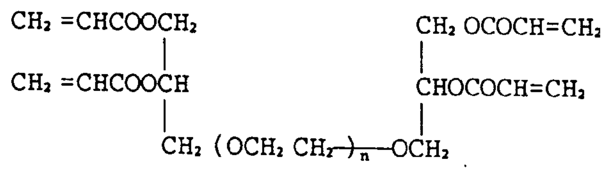

(n = 18, 23 or 30)

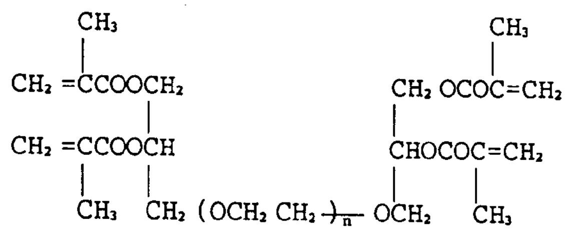

(n = 18, 23 or 30)

The water-insoluble polymer compound of the present invention is suitably selected from those compounds having film-forming ability and a molecular weight of from 5,000 to 1,000,000, more preferably 8,000 to 500,000. Examples of the polymer compound include polyester resins, vinyl chloride-vinyl acetate copolymers, acrylic resins, vinyl chloride resins, polyamide resins, epoxy resins, (meth)acrylate copolymers, polyurethane resins and vinyl acetate copolymers, but they are not specifically limited to these polymers.

The compatibility of the water-soluble compound and the water-insoluble polymer compound in the light-sensitive layer is very important to the formation of the concentrated layer of the water-soluble compounds contiguous to the interface between the light-sensitive layer and the ink-repellent layer, and the compatibility is influenced by the chemical structures of the compounds and the content ratios of the compounds in the coating solution.

After the production of the dry PS plates of the present invention, it is possible to determine whether or not the concentrated layer of the water-soluble compounds is formed at the interface of the light-sensitive layer and the ink-repellent layer by, for example, the following method.

The light-sensitive layer, not yet laminated with the ink-repellent layer, is laminated with a polyethylene terephthalate film on which a silicone rubber layer has been cured as the ink repellent layer so that the light-sensitive layer is in contact with the silicone rubber layer. One or two weeks later, the laminated film is peeled off from the light-sensitive layer and the constituents of the light-sensitive layer surface are analyzed by XPS (X-ray photo-electron spectroscopy) in a manner such as disclosed by T. G. Grasel et al., J. Biomed. Master. Res., 24, 605 (1990) and Y. Tezuka et al., J. Colloid Interface Sci., 136, 408 (1990). When a dry PS plate according to the invention is analyzed by one of those methods, it is found that less than 50% of the water-insoluble polymer compound is present at the surface portion of the light-sensitive layer of the dry PS plates as compared with the initial content of the water-insoluble compounds in the light-sensitive coating composition (dry state) and thus the content of the water-soluble compound at the surface portion of the light-sensitive layer is increased.

The light-sensitive composition used for the present invention may contain hydrophobic monomers and oligomers having polymerizable ethylenically unsaturated groups. Examples of the monomer and oligomer include:

(A) (meth)acrylic acid ester of alcohols such as ethanol, propanol, hexanol, octanol, cyclohexanol, glycerin, trimethylolpropane and pentaerythritol,

(B) reaction products of glycidyl acrylate, allylglycidyl or glycidyl methacrylate with amines such as methylamine, ethylamine, butylamine, benzylamine, ethylenediamine, hexylenediamine, diethylenetriamine, hexamethylenediamine, xylylenediamine, dimethylamine, diethylamine, ethanolamine, diethanolamine and aniline,

(C) reaction products of glycidyl acrylate, glycidyl methacrylate, allylglycidyl or tetraglycidyl-m-xylylenediamine with carboxylic acids such as acetic acid, propionic acid, benzoic acid, acrylic acid, methacrylic acid, succinic acid, maleic acid, phthalic acid, tartaric acid and citric acid,

(D) amide derivatives such as acrylamide, methacrylamide, N-methylolacrylamide and methylenebisacrylamide,

(E) reaction products of epoxy compounds with (meth)acrylic acid.

Examples of the monomer and oligomer further include urethane acrylates such as disclosed in J.P. KOKOKU Nos. Sho 48-41708, Sho 50-6034 and J.P. KOKAI No. 51-37193, polyester acrylates such as disclosed in J.P. KOKAI No. Sho 48-64183, J.P. KOKOKU Nos. Sho 49-43191 and Sho 52-30490, polyfunctional (meth)acrylates such as epoxy(meth)acrylates obtained by reacting epoxy resins with (meth)acrylic acid and N-methylolacrylamide derivatives disclosed in U.S. Pat. 4,540,649. In addition, the photocuring monomers and oligomers disclosed in NIPPON SETCHAKU KYOKAI SHI (Bulletin of the Japan Adhesives Association), Vol. 20, No. 7 (1984), p300-308 may be also used in the present invention.

These monomers and oligomers may be used alone or in any combination, and the polyfunctional monomers may simultaneously have different unsaturated groups comprising acrylic, methacrylic and allyl groups.

The water-soluble compounds, the hydrophobic monomers and oligomers may be contained in the light-sensitive layer in an amount of from 5 to 80% by weight, preferably from 30 to 70% by weight of the total weight of the light-sensitive layer composition. The weight ratio of the water-soluble compound to the hydrophobic monomers and oligomers is preferably in the range of 1:10 to 10:1.

The water-insoluble polymer compound may be contained in the light-sensitive layer in an amount of from 10 to 90% by weight, preferably from 25 to 70% by weight of the total weight of the light-sensitive layer composition.

Examples of the photopolymerization initiators used in the present invention include vicinal polyketaldonyl compounds as disclosed in U.S. Pat. No. 2,367,660; $\alpha$-carbonyl compounds as disclosed in U.S. Pat. Nos. 2,367,661 and 2,367,670; acyloin ethers as disclosed in U.S. Pat. No. 2,448,828; aromatic acyloin compounds having the $\alpha$-position substituted with a hydrocarbon group as disclosed in U.S. Pat. No. 2,722,512; polynuclear quinone compounds as disclosed in U.S. Pat. Nos. 3,046,127 and 2,951,758; a combination of a triarylimidazole dimer and p-aminophenyl ketone as disclosed in U.S. Pat. No. 3,549,367; benzothiazole compounds as disclosed in U.S. Pat. No. 3,870,524; benzothiazole compounds/trihalomethyl-s-triazine compounds as disclosed in U.S. Pat. No. 4,239,850; acridine and phenadine compounds as disclosed in U.S. Pat. No. 3,751,259; oxadiazole compounds as disclosed in U.S. Pat. No. 4,212,970; trihalomethyl-s-triazine compounds having a chromophoric group as disclosed in U.S. Pat. Nos. 3,954,475 and 4,189,323 and J.P. KOKAI Sho Nos. 53-133428, 60-105667, 62-58241 and 61-227489; and peroxy ester compounds containing a benzophenone group as disclosed in J.P. KOKAI Nos. 59-197401 and 60-76503. These photopolymerization initiators may be used alone or in combination.

The amount of the photopolymerization initiator to be added is in a range of from 0.1 to 30 %, preferably from 5 to 20 % by weight based on the total light-sensitive composition.

In addition to the foregoing components, the photopolymerizable light-sensitive composition preferably comprises a heat polymerization inhibitor. Examples of useful heat polymerization inhibitors include hydroquinone, p-methoxyphenol, di-t-butyl-p-cresol, pyrogallol, t-butylcatechol, benzoquinone, 4,4′-thiobis(3-methyl-6-t-butylphenol), 2,2′-methylenebis(4-methyl-6-t-butylphenol), 2-mercaptobenzimidazole and phenol resins. Further, the photopolymerizable light-sensitive composition may optionally comprise dyes or pigments for coloring the photopolymerizable light-sensitive layer and/or pH indicators or leuco dyes as agents or compositions for obtaining a visible image immediately after imagewise exposure. The photopolymerizable light-sensitive composition may further comprise a small amount of a silicone compound such as polydimethyl siloxane, methylstyrene-modified polydimethyl siloxane, olefin-modified polydimethyl siloxane, polyether-modified polydimethyl siloxane, silane coupling agents, silicone diacrylate or silicone dimethacrylate. In order to improve the coating properties of the light-sensitive composition, a silicon atom-containing surfactant or a fluorine atom-containing surfactant can be incorporated into the light-sensitive composition. Moreover, a diazo resin may be added to the photopolymerizable light-sensitive composition for improving the adhesion between the photopolymerizable light-sensitive layer and a primer layer, which is described later.

The amount of these additives to be added to the photopolymerizable light-sensitive composition is in general not more than 10% by weight based on the total weight of the composition.

Moreover, it is also possible to add to the photopolymerizable light-sensitive composition, silica powder or hydrophobic silica powder whose particle surface is treated with a (meth)acryloyl group- and/or allyl group-containing silane coupling agent in an amount of not more than 50 % by weight of the composition in order to improve the adhesion between the photopolymerizable light-sensitive layer and the ink-repellent layer of silicone rubber provided thereon.

The composition for the foregoing light-sensitive layer is dissolved in an appropriate solvent such as 2-methoxyethanol, 2-methoxyethyl acetate, propylene glycol methylethyl ether acetate, methyl lactate, ethyl lactate, propylene glycol monomethyl ether, methanol, ethanol, methyl ethyl ketone, water or any combination thereof, then applied to the substrate and dried. The amount of the layer applied suitably ranges from about 0.1 to 20 g/m$^2$, preferably from 0.5 to 10 g/m$^2$ (weighed after drying).

The dry PS plate of the present invention must yield a lithographic printing plate which has sufficient flexibility to allow the printing plate to be set on a conventional printing press and which can withstand the load applied thereto during the printing operation. Thus, a substrate for the dry PS plate of the invention is typically selected from the group consisting of coated paper, a metal plate such as an aluminum plate, a plastic film such as a polyethylene terephthalate film, a rubber plate and composite plates. The surface of the substrate can be coated with a primer layer or the like for preventing halation and for other purposes.

In the preparation of the primer layer, various materials can be employed to improve the adhesion between the substrate and the photopolymerizable light-sensitive layer, to prevent halation, to dye images and/or to enhance the printing properties of the resulting lithographic printing plate. Examples of these materials include those obtained by exposing to light a variety of light-sensitive polymers to cure them prior to the application of the photopolymerizable light-sensitive layer, as disclosed in J.P. KOKAI No. Sho 60-229031; those obtained by heat curing of epoxy resins, as disclosed in J.P. KOKAI No. Sho 62-50760; those obtained by hardening gelatin films, as disclosed in J.P. KOKAI No. Sho 63-133151; those using urethane resin as disclosed in Japanese Patent Application Nos. Hei 2-81896 and 2-21072 and hardened casein films. With the aim of softening the primer layer, it may be admixed with a polymer having a glass transition point lower than room temperature such as those selected from polyurethanes, polyamides, styrene/butadiene rubbers, carboxyl-modified styrene/butadiene rubbers, acrylonitrile/butadiene rubbers, carboxyl-modified acrylonitrile/butadiene rubbers, polyisoprenes and acrylate rubbers, polyethylenes, chlorinated polyethylenes and chlorinated polypropylenes. The amount of the polymer to be added is not particularly limited, and the primer layer may be composed of the polymer alone so long as the polymer is able to form a film.

The primer layer may also comprise, depending on the foregoing purposes, additives such as dyes, pH indicators, agents or compositions for obtaining a visible image immediately after imagewise exposure to light, photopolymerization initiators, adhesion improvers (e.g., polymerizable monomers, diazo resins, silane coupling agents, titanate coupling agents or aluminum coupling agents), white pigments and/or silica powder. The amount of the primer layer to be applied ranges generally from 0.1 to 20 g/m$^2$ , preferably from 1 to 10 g/m$^2$ (determined after drying).

The ink-repellent layer of the present invention may be composed of crosslinked silicone rubber, fluorine resins or the like.

The crosslinked silicone rubber layer used in the present invention is a layer of partially or completely crosslinked polydiorganosiloxane comprising the following repeating unit:

$$-Si(R)_2-O-$$

wherein R represents a monovalent group such as an alkyl, aryl or alkenyl group or a combination thereof, which may have functional groups selected from the group consisting of halogen atoms, amino groups, hydroxyl group, alkoxy groups, aryloxy groups, (meth)acryloxy groups and thiol groups. The silicone rubber layer may optionally comprise fine powder of an inorganic compound such as silica, calcium carbonate or titanium oxide; an auxiliary agent for adhesion such as the aforementioned silane coupling agents, titanate coupling agents or aluminum coupling agents; and/or a photopolymerization initiator.

Polysiloxanes having functional groups at the ends thereof and a molecular weight of from several thousands to several hundreds of thousand are in general used as starting materials for polymers (silicone rubbers) having the foregoing polysiloxane chain as the main skeleton. The silicone rubber layer can be obtained by crosslinking and hardening the starting material by a method involving mixing the foregoing polysiloxane having hydroxyl group(s) at either or both of the ends thereof with a silane coupling agent represented by the following general formula, adding, if necessary, an organic metal compound such as organotin compound, an inorganic acid or an amine as a catalyst and, condensing and hardening the polysiloxane and the silane coupling agent with heating or at room temperature:

$$R_nSiX_{4-n}$$

wherein n is an integer of 1 to 3; R has the same meaning as defined above; and X represents a substituent such as -OH, -OR$^2$ , -OAc, -O-N=CR$^2$ R$^3$ , -Cl, -Br or -I where R$^2$ and R$^3$ may be the same or different and each has the same meaning as that for R defined above and Ac represents an acetyl group.

Alternatively, the silicone rubber layer may be obtained by condensing and hardening the organopolysiloxane carrying hydroxyl group(s) at the ends thereof, a hydrogen polysiloxane crosslinking agent and an optional silane coupling agent defined above.

Useful examples of the silicone rubber layer further include addition type silicone rubber layer obtained

by crosslinking ≡ SiH groups and -CH=CH- groups through an addition reaction. The addition type silicone rubber layer is relatively unaffected by humidity during hardening the same and undergoes crosslinking at high speed, so that a crosslinked silicone rubber layer having predetermined physical properties can easily be formed.

The addition type silicone rubber layer herein used can be one obtained through a reaction of polyvalent hydrogen organopolysiloxane with a polysiloxane compound having two or more -CH=CH- bonds in the molecule and desirably one obtained by hardening and crosslinking a composition comprising the following components:

(1) 100 parts by weight of an organopolysiloxane having at least two alkenyl groups, preferably vinyl groups, directly bonded to the silicon atom of each molecule;

(2) 0.1 to 1,000 parts by weight of an organo hydrogen polysiloxane having at least two ≡ SiH bonds per molecule; and

(3) 0.00001 to 10 parts by weight of an addition catalyst.

The alkenyl groups of Component (1) may be present either in the middle of or at the ends of the molecular chain and the organopolysiloxane may have organic substituents other than the alkenyl group, such as substituted or unsubstituted alkyl and aryl groups. Component (1) may contain a small number of hydroxyl groups. Component (2) is reacted with Component (1) to form a silicone rubber layer and serves to enhance the adhesive property of the silicone rubber layer to the photopolymerizable light-sensitive layer. The hydrogen atom of Component (2) may be present in the middle of or at the end of the molecular chain and Component (2) may in addition to the hydrogen atom also have organic groups, selected from the group consisting of those defined above in connection with Component (1). It is preferred that at least 60% of the organic groups of Components (1) and (2) be methyl groups from the viewpoint of ink repellency of the resulting silicone rubber layer. Components (1) and (2) may have a linear, cyclic or branched structure and the molecular weight of at least one of them preferably exceeds 1,000 from the viewpoint of the physical properties of the rubber layer and more preferably the molecular weight of Component (1) exceeds 1,000.

Examples of Component (1) are α, ω-divinylpolydimethyl siloxane and methylvinylsiloxane/dimethylsiloxane copolymer having methyl groups at both ends; those of Component (2) are polydimethyl siloxane having hydrogen atoms at both ends, α, ω -dimethylpolymethyl hydrogensiloxane, methyl hydrogensiloxane/dimethylsiloxane copolymer having methyl groups at both ends and cyclic polymethyl hydrogensiloxane.

The addition catalysts, Component (3), may be selected from any known ones, but platinum compounds are particularly preferred and examples thereof are elemental platinum, platinum chloride, chloroplatinic acid and platinums coordinated with olefins.

The composition for obtaining the silicone rubber layer may optionally comprise a crosslinking inhibitory agent such as a vinyl group-containing organopolysiloxane (e.g., tetracyclo(methylvinyl) siloxane), a carbon-carbon triple bond-containing alcohol, acetone, methyl ethyl ketone, methanol, ethanol or propylene glycol monomethyl ether for controlling the hardening speed of the composition.

These compositions undergo an addition reaction and thus start hardening as soon as the foregoing three components are mixed together. The hardening speed increases rapidly as the reaction temperature raises. Therefore, for the purpose of shortening the time for hardening the composition on the light-sensitive layer and for extending the pot life thereof, it is preferred that the composition is maintained under a high temperature condition at which the properties of the substrate and the photopolymerizable light-sensitive layer are not changed till the composition is completely hardened. Thus, stable adhesion between the rubber layer and the light-sensitive layer can be ensured.

In addition to the foregoing components, the composition for the silicone rubber layer may comprise a known adhesion-imparting agent such as an alkenyl trialkoxysilane or those represented by the following formulae:

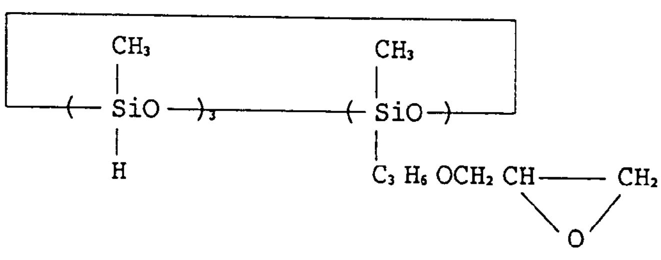

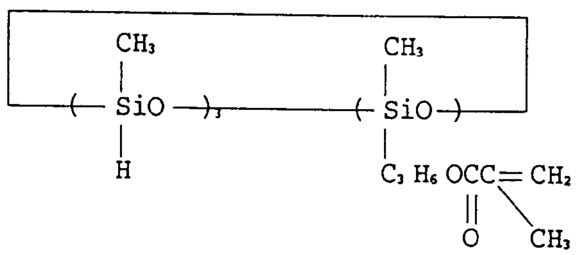

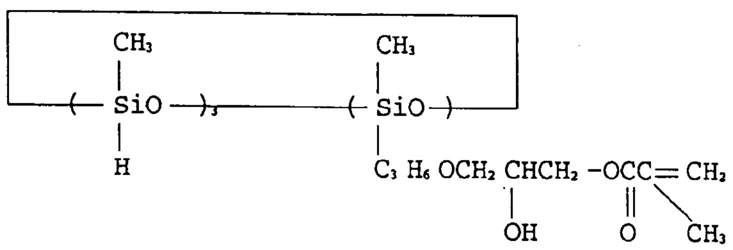

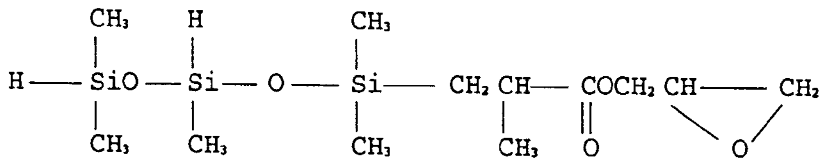

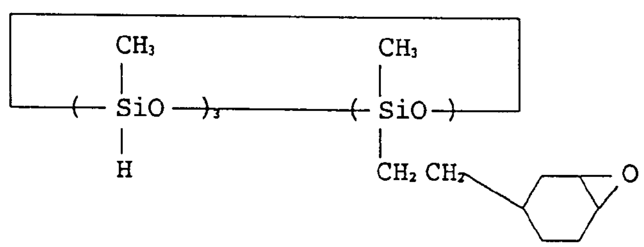

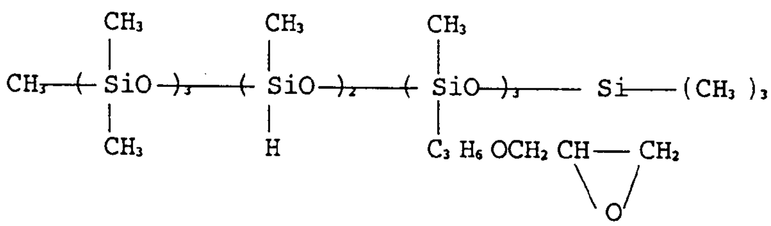

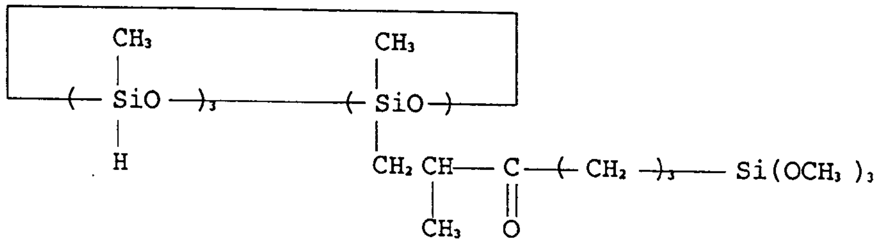

and a hydroxyl group-containing organopolysiloxane, a silicone oil consisting of polydimethylsiloxane whose end is a trimethylsilyl group, polydimethylsiloxane having a trimethylsilyl group at the end, a silicone oil consisting of a polyphenylmethylsiloxane copolymer and/or hydrolyzable functional group-containing silane (or siloxane) which are components of the condensed silicone rubber layers. Moreover, a known filler such as silica may be added to the composition in order to improve the strength of the resulting silicone rubber layer.

Examples of the crosslinked fluorine resin include those disclosed in J.P. KOKAI Nos. Sho 58-215411 and Hei 2-103047, and more specifically, those having fluorine-atom-containing units such as $CF_3$-, $-CF_2$-, >CF-, $CF_3$-O-, $-CF_2$-O- and >CF-O- as well as functional groups crosslinkable with crosslinking agents or functional groups crosslinkable with each other such as -OH, -COOH, $-NH_2$,

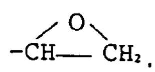

-NCO, and -NH- and having a fluorine content of not less than 30% by weight, preferably not less than 50% by weight. Fluorine resins of this sort may be obtained by copolymerization of fluorine-atom-containing (meth)acrylate monomers or fluorine-atom-containing olefin monomers optionally with (meth)acrylate monomers and vinyl monomers, but they are not limited to these examples.

In the present invention, the thinner the ink-repellent layer, the lower is the ink-repellency and if the layer is too thin, the dry PS plate has a drawback in that the layer is easily damaged. On the other, the thicker the layer, the lower is the developability of the dry PS plate. Thus, the thickness is preferably in the range of from 0.5 to 5 μm and more preferably from 1 to 3 μm.

In the dry PS plate of the present invention, it is also possible to apply a variety of other ink-repellent layers on the foregoing ink-repellent layer. Further, an adhesive layer may be applied between the photopolymerizable light-sensitive layer and the ink-repellent layer in order to enhance the adhesion between the photopolymerizable light-sensitive layer and the ink-repellent layer and to prevent poisoning of the catalyst present in the composition.

A polymer coating may be applied to the surface of the ink-repellent layer or a polymer film may be laminated on the ink-repellent layer for protecting the surface of the ink-repellent layer. Examples of such polymer coatings or films include transparent films or coatings such as polyethylene, polypropylene, polyvinyl chloride, polyvinylidene chloride, polyvinyl alcohol, polyethylene terephthalate and cellophane films or coatings. These films may be stretched before the lamination. It is also possible to provide a mat layer on the surface of the coating or the film to ensure close vacuum contact between an original transparency and the surface of the dry PS plate in a vacuum printing frame.

The dry PS plate of the present invention is first imagewise exposed to light through an original transparency and then developed with a developer capable of dissolving or swelling a part or the whole of the light-sensitive layer in image areas (unexposed areas) or a developer capable of swelling the silicone rubber layer.

The developer used in the present invention may be any known developer suitable for developing dry PS plates. Examples include aliphatic hydrocarbons such as hexane, heptane, "Isopar E, H and G" (trade names of the aliphatic hydrocarbons available from Esso Chemical Co., Ltd.), gasoline and kerosine, aromatic hydrocarbons such as toluene and xylene, and halogenated hydrocarbons such as trichloroethylene, to which one or more of the following polar solvents are added. The polar solvents may also be used by themselves.

Usable polar solvents include:

alcohols such as methanol, ethanol, propanol, isopropanol, benzyl alcohol, ethylene glycol monomethyl ether, 2-ethoxyethanol, diethylene glycol monoethyl ether, diethylene glycol monohexyl ether, triethylene glycol monomethyl ether, propylene glycol monoethyl ether, dipropylene glycol monomethyl ether, polyethylene glycol monomethyl ether, polypropylene glycol, and tetraethylene glycol;

ketones such as acetone and methyl ethyl ketone;

esters such as ethyl acetate, methyl lactate, butyl lactate, propylene glycol monomethyl ether acetate, diethylene glycol acetate and diethyl phthalate; and

other polar solvents such as triethyl phosphate and tricresyl phosphate.

It is also possible to use, as a developer, the foregoing organic solvent type developers to which water is added; developers obtained by solubilizing the foregoing organic solvent in water with the aid of a surfactant; developers obtained by adding, to the foregoing developers, an alkaline agent such as sodium carbonate, diethanolamine or sodium hydroxide; or water itself including tap water, pure water and distilled water.

Though as described above any of the conventional developers may be used in the present invention, the content of the organic solvent is preferably less than 40% by weight of the developer from the viewpoint of industrial hygiene and inflammability. More preferably, the developer is composed of water or an aqueous solution of organic solvents containing water as the main component.

In the present invention, a dye such as Crystal Violet or Astrazone Red can be added to the developer to dye the image simultaneously with the development.

The development of the dry PS plate of the present invention can be performed by any known method, for instance, by rubbing the plate surface with a developing pad containing the foregoing developer or by pouring the developer onto the plate surface and then rubbing the surface with a developing brush in water. The temperature of the developer is not particularly defined, but the development is preferably carried out in a developer whose temperature is in the range of from 10 to 80 °C. As a result of the development, the ink-repellent layer and the light-sensitive layer in the image areas are removed to reveal the surface of the substrate or the primer layer which serves as an ink receiving part, or only the ink-repellent layer is removed to reveal the light-sensitive layer which serves as an ink receiving part.

The exposed image areas of the resulting printing plates are dyed with a dyeing solution and thus detected to evaluate the image-forming ability of the plate. When the developer does not contain a dye for dyeing the image areas, the printing plates may be treated with a dyeing solution after the development. Only the exposed areas on the light-sensitive layer are dyed when the image areas are lightly rubbed with a soft pad impregnated with the dyeing solution and this makes it possible to confirm whether even the highlight portions on the image areas are sufficiently developed or not. The dyeing solution used comprises, for instance, at least one member selected from the group consisting of water-soluble disperse dyes, acid dyes and basic dyes which are dissolved or dispersed in a solvent selected from the group consisting of water, alcohols, ketones, ethers and mixture thereof. It is also effective to incorporate carboxylic acids, amines, surfactants and/or dyeing aids to enhance the dyeing properties of the solution.

The lithographic printing plates dyed with the dyeing solution are then preferably washed with water and dried to suppress the adhesion of the plate surface. This also facilitates the handling of the plates.

When the lithographic plates are stacked, it is preferable to insert a sheet of paper between adjacent plates to protect the surfaces of the printing plates.

The development and dyeing processes as well as the subsequent washing and drying processes are preferably carried out by an automatic processing machine. A preferred automatic processing machine is described, for instance, in J.P. KOKAI No. Hei 2-220061.

According to the present invention, there are provided dry PS plates exhibiting excellent developability of image areas, and the dry PS plates can be stably developed with a safe developer, i.e., water or an aqueous solution of water-soluble organic solvents mainly composed of water.

## Examples

The present invention will hereinafter be explained in more detail with reference to the following non-limitative working Examples and the practical effects achieved by the invention will also be discussed in detail in comparison with Comparative Examples.

### Examples 1 to 12 and Comparative Examples 1 to 5

A JIS A 1050 aluminum plate having a thickness of 0.3 mm which had been degreased in the usual manner was dipped in a 1% aqueous solution of an aminosilane coupling agent, KBM 603 (available from Shin-Etsu Chemical Co., Ltd.), and then dried at room temperature. Then the following primer solution was applied onto the aluminum plate so that the coating weight thereof was 4 g/m$^2$ (after drying) and heated at 140°C for 2 minutes to dry and harden the film.

Primer layer solution

| Component | Amount (parts by weight) |
|---|---|
| Sanprene IB 1700D (30% solution of thermoplastic polyurethane resin having a terminal hydroxyl group in methyl ethyl ketone; available from Sanyo Chemical Industries, Ltd.) | 10 |
| Takenate D 110N (75% solution of a polyfunctional isocyanate compound in ethyl acetate; available from Takeda Chemical Industries, Ltd.) | 0.5 |
| $TiO_2$ | 0.1 |
| Defenser MCF 323 (30% solution of fluorine atom-containing nonionic surfactant in methyl isobutyl ketone; available from Dainippon Ink And Chemicals, Inc.) | 0.03 |
| Propylene glycol methyl ether acetate | 50 |
| Methyl lactate | 20 |

A solution of a photopolymerizable light-sensitive composition having the following composition was applied onto the primer layer thus formed on the aluminum plate in an amount of 5 g/m² (after drying) and then dried at 100 °C for one minute.

Light-sensitive layer solution

| Component | Amount (parts by weight) |
|---|---|
| Water-insoluble polymer compound shown in Table 1 | |
| Water-soluble compound shown in Table 1 | |
| Adduct of xylenediamine (1 mole) with glycidyl methacrylate (4 moles) | 1.0 |
| Ethyl Michler's ketone | 0.35 |
| 2,4-Diethylthioxantone | 0.10 |
| Naphthalenesulfonate of Victoria Pure Blue BOH | 0.01 |
| Defenser MCF 323 | 0.03 |
| Methyl ethyl ketone | 15 |
| Propylene glycol methyl ether | 20 |

Then, a solution of a composition for ink-repellent layer having the following composition was applied onto the photopolymerizable light-sensitive layer so that the coating weight thereof was 2.0 g/m² (on dry basis) and dried at 140°C for 2 minutes.

Ink-repellent layer solution

| Component | Amount (parts by weight) |
|---|---|
| α,ω-Divinylpolydimethylsiloxane (degree of polymerization = about 700) | 9 |
| $(CH_3)_3Si-O-(Si(CH_3)_2-O)_{30}-(SiH(CH_3)-O)_{10}-Si(CH_3)_3$ | 1 |
| Polydimethylsiloxane (degree of polymerization = about 8,000) | 0.5 |
| Olefin-chloroplatinic acid | 0.2 |
| Inhibitor | 0.3 |
| Isopar G (available from Esso Chemical Co., Ltd.) | 140 |

A one-side matted biaxially stretched polypropylene film having a thickness of 12 μm was laminated on the silicone rubber layer thus produced so that the non-matted side thereof came in contact with the silicone rubber layer, to give a dry PS plate.

Table 1

| Example No. | Water-insoluble polymer compound (parts by weight) | Water-soluble compound (parts by weight) |
|---|---|---|
| 1 | P (1.5) | I (0.8) |
| 2 | P (2.0) | II (0.5) and IX (0.5 ) |
| 3 | A (1.5) | III (0.5) and X (0.3 ) |
| 4 | A (1.5) | III (0.2) and IV (0.4 ) |
| 5 | A (2.0) | IV (0.6) and V (0.4 ) |
| 6 | B (1.5) | IV (0.7) |
| 7 | B (1.5) | II (0.8) |
| 8 | C (1.5) | IV (0.6) |
| 9 | D (1.5) | V (0.5) and XI (0.3 ) |
| 10 | E (1.5) | IV (0.8) |
| 11 | F (1.5) | III (0.8) |
| 12 | Q (1.5) | I (0.6) and IV (0.4 ) |
| Comparative Example No. | | |
| 1 | A (1.5) | VI (0.8) |
| 2 | A (2.0) | IV (0.4) |
| 3 | B (1.5) | VII (0.6) |
| 4 | B (1.5) | III (0.3) |
| 5 | C (1.5) | VIII (0.4) |

Water-insoluble polymer compound

P: Crysbon 3006 LV (polyurethane resin available from Dainippon Ink and Chemicals Inc.)

A: Polyurethane resin (isophorone diisocyanate/polyester(adipic acid/1,4-butanediol/ethylene glycol)/1,4-butanediol/isophoronediamine, molar ratio = 1.0/0.2/0.6/0.2)

B: Polyurethane resin (isophorone diisocyanate/polyester(adipic acid/1,6-hexamethylenediol/ethylene glycol)/1,6-hexamethylenediol/di(p-aminophenyl)methane, molar ratio = 1.0/0.3/0.6/0.1)

C: Polyurethane resin (1,6-hexamethylenediisocyanate/polyester(adipic acid/1,4-butanediol/ethylene glycol)/1,4-butanediol/1,6-hexamethylenediamine, molar ratio = 1.0/0.1/0.5/0.3)

D: Polyurethane resin (isophorone diisocyanate/polyethylene glycol/1,4-butanediol/isophoronediamine,

molar ratio = 1.0/0.5/0.3/0.2)

E: Polyamide resin (1,3-bis(aminomethyl)cyclohexane/cyclohexane-1,4-dicarboxylic acid/1,6-hexamethylenediamine/adipic acid/ε-caprolactam, molar ratio = 1.0/1.0/1.0/1.0/1.0)

F: Copolymer of t-butylacrylamide/styrene/butyl acrylate (molar ratio = 1.0/0.5/0.5)

Q: Sanprene IB 1700D

Water-soluble compound

I: Sartomer 9035 (water-soluble trifunctional monomer available from Sartomer Co.,Ltd.)

II: 23G (polyethylene oxide dimethacrylate (molar number of ethylene oxide (n) = 23) available from Sin Nakamura Kagaku Co.,Ltd.)

III: A600 (polyethylene oxide diacrylate (n = 14) available from Sin Nakamura Kagaku Co.,Ltd.)

IV: A1000 (polyethylene oxide diacrylate (n = 23) available from Sin Nakamura Kagaku Co.,Ltd.)

V: 14G (polyethylene oxide dimethacrylate (n = 14) available from Sin Nakamura Kagaku Co.,Ltd.)

VI: A200 (polyethylene oxide diacrylate (n = 4) available from Sin Nakamura Kagaku Co.,Ltd.)

VII: Sartomer 454 (water-soluble trifunctional monomer available from Sartomer Co.,Ltd.)

VIII: 9G (polyethylene oxide dimethacrylate (n = 9) available from Sin Nakamura Kagaku Co.,Ltd.)

IX: Polypropylene glycol (Mw: about 1,500)

X: M90G (polyethylene oxide monomethyl ether methacrylate (n = 9) available from Sin Nakamura Kagaku Co.,Ltd.)

XI: M230G (polyethylene oxide monomethyl ether methacrylate (n = 23) available from Sin Nakamura Kagaku Co.,Ltd.)

A positive film carrying a half tone dot image (200 lines/inch or 25.4 mm) and a gray scale having an optical density difference of 0.15 were put on the dry PS plates and a commercially available dry PS plate, TAP · HGII (Toray Inc.), and the plates were exposed to light with a vacuum exposure machine (available from Nu Arc Co., Ltd. under the trade name of FT261V UDNS Ultra-Plus Fliptop Plate Maker) for 30 counts, respectively. Then the laminate films were peeled off from the plates and the plates were subjected to the following developing treatment A or B.

Developing treatment A

The light-exposed dry PS plates were immersed in a 20% aqueous solution of ethylene glycol maintained at 40°C for on e minute and rubbed with a pad for development in the solution to remove the silicone rubber layer from the non-exposed areas. The resulting printing plates were dyed with a dyeing solution having the following composition to determine the developability of the plates.

Further, the half tone dot reproduction observed at the gray scale sensitivity corresponding to the solid steps of 9 (expressed in the half tone dot area of reproducible highlight portions) was determined. The results are shown in Table 2.

Developing treatment B

The light-exposed dry PS plates were immersed in water maintained at 35°C and rubbed with a pad in the water to remove the silicone rubber layer from the non-exposed areas. The resulting printing plates were dyed with a dyeing solution having the following composition to determine the developability of the plates.

Further, the half tone dot reproduction observed at the gray scale sensitivity corresponding to the solid steps of 9 (expressed in the half tone dot area of reproducible highlight portions) was determined. The results are shown in Table 2.

Dyeing solution

| | (parts by weight) |
|---|---|
| Crystal Violet | 0.1 |
| Ethylene glycol | 15 |
| Pure water | 85 |

As seen from the results in Table 2, the dry PS plates of the present invention exhibit excellent developability and tone-reproducibility in both of developing treatments A and B, the latter using only water.

Table 2

| Sample | Remaining Polymer Compound[1)] (%) | Development treatment A | | B | |
|---|---|---|---|---|---|
| | | Developability[2)] | Tone-reproducibility[3)] | Developability[2)] | Tone-reproducibility[3)] |
| Ex. 1 | 25 | ○ | 2 | ○ | 2 |
| Ex. 2 | 20 | ○ | 3 | ○ | 3 |
| Ex. 3 | 35 | ○ | 3 | ○ | 3 |
| Ex. 4 | 25 | ○ | 2 | ○ | 2 |
| Ex. 5 | 25 | ○ | 2 | ○ | 2 |
| Ex. 6 | 20 | ○ | 2 | ○ | 2 |
| Ex. 7 | 25 | ○ | 2 | ○ | 2 |
| Ex. 8 | 30 | ○ | 2 | ○ | 2 |
| Ex. 9 | 25 | ○ | 3 | ○ | 3 |
| Ex. 10 | 20 | ○ | 2 | ○ | 2 |
| Ex. 11 | 30 | ○ | 2 | ○ | 2 |
| Ex. 12 | 25 | ○ | 3 | ○ | 3 |
| C.Ex. 1 | 85 | × | 8 | × | 20 |
| C.Ex. 2 | 75 | × | 6 | × | 10 |
| C.Ex. 3 | 90 | × | 8 | × | 15 |
| C.Ex. 4 | 80 | × | 8 | × | 15 |
| C.Ex. 5 | 90 | × | 10 | × | 20 |
| TAP・HGII | - | × | 8 | × | 15 |

1) The amount of the water-insoluble polymer compound remaining in the surface portion of the light-sensitive layer was analyzed by XPS and expressed in % to the initial content of the compound in the light-sensitive composition (dry state).

2) Developability was evaluated from remaining silicone rubber in the solid portions. ○ : not observed, × : observed.
3) Tone-reproducibility was expressed by the half tone dot area of reproducible highlight portions in %.
Ex. = Example, C.Ex. = Comparative Example

Example 13

The same kind of aluminum plate as used in Examples 1 to 12 was applied with the following primer solution so that the coating weight thereof was 3 g/m$^2$ (weighed after drying) and heated at 140 °C for 2 minutes to dry and harden the film.

Primer solution

Primer solution

| Component | Amount (parts by weight) |
|---|---|
| Crysbon 3006LV | 15 |
| $PF_6$ salt of p-diazodiphenylamine/paraformaldehyde condensate | 0.1 |
| $TiO_2$ | 0.5 |
| Defenser MCF 323 | 0.03 |
| Propylene glycol monomethyl ether | 100 |
| Methyl ethyl ketone | 50 |
| Methyl lactate | 5 |
| Pure water | 2 |

Then, the same kind of light-sensitive layer, silicone rubber layer and cover film as used in Example 4 were laminated on the primer layer, and the resulting dry PS plate was evaluated in the same manner as in Examples 1 to 12 except that light exposure was carried out for 10 counts.

The dry PS plate showed excellent developability and 2% of reproducible highlight portions in both of developing treatments A and B.

Example 14

A dry PS plate was prepared in the same manner as in Example 4 except that, instead of the silicone rubber layer of Example 4, a silicone rubber solution having the following composition was applied on the light-sensitive layer so that the coating weight thereof was 2 g/m$^2$ (on dry basis) and dried at 120°C for 2 minutes.

| Component | Amount (parts by weight) |
|---|---|
| $\alpha,\omega$-Dihydroxypolydimethylsiloxane (degree of polymerization = about 700) | 9 |
| Methyltriacetoxysilane | 0.3 |
| Trimethoxysilylpropyl-3,5-diallylisocyanurate | 0.3 |
| Dibutyltin dioctanoate | 0.03 |
| Isopar G (Esso Chemical Co., Ltd.) | 160 |

The resulting dry PS plate was evaluated in the same manner as in Examples 1 to 12 and it was found that the dry PS plate showed excellent developability and 2% of reproducible highlight portions in both of developing treatments A and B.

## Claims

1. A dry PS plate which comprises a substrate having a photopolymerizable light-sensitive layer and an ink-repellent layer in that order, wherein the light-sensitive layer contains at least one water-soluble compound and at least one water-insoluble polymer compound which compounds cause phase separation in the light-sensitive layer to form a layer rich in the water-soluble compound contiguous to the interface of the light-sensitive layer and the ink-repellent layer so that the surface portion of the light-sensitive layer contiguous to the interface of the light-sensitive layer and the ink-repellent layer has a concentration of the remaining water-insoluble polymer of less than 50% as compared with the initial content of the water-insoluble compound in the light-sensitive coating composition.

2. The dry PS plate according to claim 1, wherein the water-soluble compound has at least one polymerizable ethylenically unsaturated group.

3. The dry PS plate according to any of the preceding claims, wherein the water-soluble compound is selected from the following compounds:
$HO-(CH_2CH_2O)_n-H$ (Mw: about 400, 600, 1000, 1500 or 4000)
$HO-(CH_2CH(CH_3)O)_n-H$ (Mw: about 500, 1000 or 2000)
$HO-(CH_2CH_2O)_n-(CH_2CH(CH_3)O)_m-H$ (Mw: about 500, 1000 or 2000)
$CH_2=C(CH_3)COO(CH_2CH_2O)_n-CH_3$ (n = 9, 14 or 23)
$CH_2=CHCOO(CH_2CH_2O)_n-CH_3$ (n = 9, 14 or 23)
$CH_2=CHCOOCH_2CH_2OCOCH_2CH_2COOH$
$CH_2=CHCOO(CH_2CH_2O)_n-COCH=CH_2$ (n = 9, 14 or 23)
$CH_2=C(CH_3)COO(CH_2CH_2O)_n-COC(CH_3)=CH_2$ (n = 9, 14 or 23)
$CH_2=CHCOO(CH_2CH(CH_3)O)_n-COCH=CH_2$ (n = 18 or 23)
$CH_2=CHCOO(CH_2CH_2O)_n-(CH_2CH(CH_3)O)_m-COCH=CH_2$ (m + n = 18, 25 or 30)
$CH_2=C(CH_3)COO(CH_2CH_2O)_n-COCH=CH_2$ (n = 18, 28 or 36)

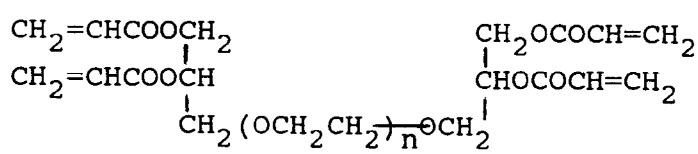

(n = 18, 23 or 30)

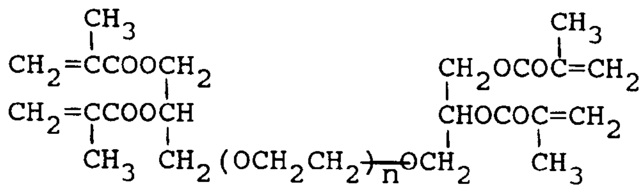

(n = 18, 23, or 30)

4. The dry PS plate according to any of the preceding claims, wherein the water-insouble polymer compound is selected from those compounds having film-forming ability and a molecular weight of from 5,000 to 1,000,000.

5. The dry PS plate according to any of the preceding claims, wherein the water-insoluble polymer compound is selected from polyester resins, vinyl chloride-vinyl acetate copolymers, acrylic resins, vinyl chloride resins, polyamide resins, epoxy resins, (meth)acrylate copolymers, polyurethane resins and vinyl acetate resins.

6. The dry PS plate according to any of the preceding claims, wherein the light-sensitive layer contains one or more hydrophobic monomers and oligomers having polymerizable ethylenically unsaturated groups in an amount of 5 to 80% by weight of the total weight of the light-sensitive composition.

7. The dry PS plate according to any of the preceding claims, wherein the weight ratio of the water-soluble compound and the hydrophobic monomers or oligomers is in a range of from 1:10 to 10:1.

8. The dry PS plate according to any of the preceding claims, wherein the water-insoluble polymer compound is contained in an amount of 10 to 90% by weight of the total weight of the light-sensitive composition.

9. The dry PS plate according to any of the preceding claims, which further contains a primer layer between the substrate and the light-sensitive layer.

10. Use of the dry PS plate according to any of claims 1 to 9 in preparing a lithographic printing plate not requiring dampening with water.

**Patentansprüche**

1. Trockene PS-Platte (vorsensibilisierte Platte), welche ein Substrat mit einer photopolymerisierbaren lichtempfindlichen Schicht und einer druckfarbenabstoßenden Schicht in dieser Reihenfolge umfaßt, worin die lichtempfindliche Schicht mindestens eine wasserlösliche Verbindung und mindestens eine wasserunlösliche Polymerverbindung enthält, wobei diese Verbindungen eine Phasentrennung in der lichtempfindlichen Schicht verursachen unter Bildung einer Schicht, die reich an der wasserlöslichen Verbindung ist, welche an die Grenzfläche der lichtempflindlichen Schicht und der druckfarbenabstoßenden Schicht angrenzt, so daß der Oberflächenteil der lichtempfindlichen Schicht, der an die Grenzfläche der lichtempfindlichen Schicht und der druckfarbenabstoßenden Schicht angrenzt, eine Konzentration des verbleibenden wasserunlöslichen Polymers von weniger als 50 % im Vergleich zu dem ursprünglichen Gehalt der wasserunlöslichen Verbindung in der lichtempfindlichen Überzugszusammensetzung hat.

2. Trockene PS-Platte nach Anspruch 1, worin die wasserlösliche Verbindung mindestens eine polymerisierbare ethylenisch ungesättigte Gruppe hat.

3. Trockene PS-Platte nach einem der vorhergehenden Ansprüche, worin die wasserlösliche Verbindung gewählt wird aus den folgenden Verbindungen :

$HO-(CH_2CH_2O)_n-H$ (MG: etwa 400, 600, 1000, 1500 oder 4000)

$HO-(CH_2CH(CH_3)O)_n-H$ (MG: etwa 500, 1000 oder 2000)

$HO-(CH_2CH_2O)_n-(CH_2CH(CH_3)O)_m-H$ (MG: etwa 500, 1000 oder 2000)

$CH_2=C(CH_3)COO(CH_2CH_2O)_n-CH_3$ (n = 9, 14 oder 23)

$CH_2=CHCOO(CH_2CH_2O)_n-CH_3$ (n = 9, 14 oder 23)

$CH_2=CHCOOCH_2CH_2OCOCH_2CH_2COOH$
$CH_2=CHCOO(CH_2CH_2O)_n-COCH=CH_2$ (n = 9, 14 oder 23)
$CH_2=C(CH_3)COO(CH_2CH_2O)_n-COC(CH_3)=CH_2$ (n = 9, 14 oder 23)
$CH_2=CHCOO(CH_2CH(CH_3)O)_n-COCH=CH_2$ (n = 18 order 23)
$CH_2=CHCOO(CH_2CH_2O)_n-(CH_2CH(CH_3)O)_m$ $-COCH=CH_2$ (m + n = 18, 25 oder 30)
$CH_2=C(CH_3)COO(CH_2CH_2O)_n-COCH=CH_2$ (n = 18, 28 oder 36)

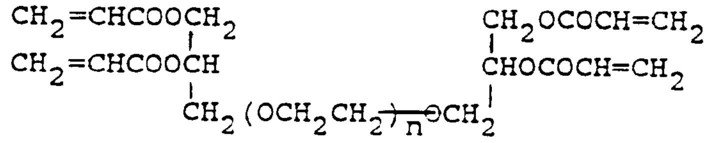

(n = 18, 23 **oder** 30)

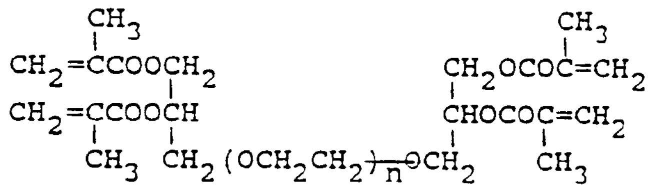

(n = 18, 23, **oder** 30)

4. Trockene PS-Platte nach einem der vorhergehenden Ansprüche, worin die wasserunlösliche Polymerverbindung gewählt wird aus Verbindungen, die einen Film bilden können und ein Molekulargewicht von 5.000 bis 1.000.000 haben.

5. Trockene PS-Platte nach einem der vorhergehenden Ansprüche, worin die wasserunlösliche Polymerverbindung gewählt wird aus Polyesterharzen, Vinylchlorid-Vinylacetat-Copolymeren, Acrylharzen, Vinylchloridharzen, Polyamidharzen, Epoxyharzen, (Meth)acrylat-Copolymeren, Polyurethanharzen und Vinylacetatharzen.

6. Trockene PS-Platte nach einem der vorhergehenden Ansprüche, worin die lichtempfindliche Schicht ein oder mehrere hydrophobe Monomere und Oligomere mit polymerisierbaren ethylenisch ungesättigten Gruppen in einer Menge von 5 bis 80 Gew.%, bezogen auf das Gesamtgewicht der lichtempfindlichen Zusammensetzung, enthält.

7. Trockene PS-Platte nach einem der vorhergehenden Ansprüche, worin das Gewichtsverhältnis der wasserlöslichen Verbindung und der hydrophoben Monomere oder Oligomere in einem Bereich von 1:10 bis 10:1 liegt.

8. Trockene PS-Platte nach einem der vorhergehenden Ansprüche, worin die wasserunlösliche Polymerverbindung in einer Menge von 10 bis 90 Gew.%, bezogen auf das Gesamtgewicht der lichtempfindlichen Zusammensetzung, enthalten ist.

9. Trockene PS-Platte nach einem der vorhergehenden Ansprüche, welche ferner eine Grundierungsschicht zwischen dem Substrat und der lichtempfindlichen Schicht enthält.

10. Verwendung der trockenen PS-Platte nach einem der Ansprüche 1 bis 9 beim Herstellen einer lithographischen Druckplatte, die kein Befeuchten mit Wasser erfordert.

**Revendications**

1. Plaque présensibilisée sèche qui comprend un support ayant une couche photopolymérisable photosensible et une couche repoussant l'encre, dans cet ordre, dans laquelle la couche photosensible contient au moins un composé soluble dans l'eau et au moins un polymère insoluble dans l'eau, composés qui provoquent la séparation de phases dans la couche photosensible pour former une couche riche en composé soluble dans l'eau contiguë à l'interface de la couche photosensible et de la couche repoussant l'encre, de sorte que la portion de surface de la couche photosensible contiguë à l'interface de la couche photosensible et de la couche repoussant l'encre a une concentration du polymère insoluble dans l'eau restant de moins de 50%, comparée à la teneur initiale en composé insoluble dans l'eau dans la composition de revêtement photosensible.

2. Plaque présensibilisée sèche selon la revendication 1, dans laquelle le composé soluble dans l'eau a au moins un groupe éthylénique polymérisable.

3. Plaque présensibilisée sèche selon l'une quelconque des revendications précédentes, dans laquelle le composé soluble dans l'eau est choisi parmi les composés suivants:

$HO-(CH_2CH_2O)_n-H$ (PM: environ 400, 600, 1000, 1500 ou 4000)
$HO-(CH_2CH(CH_3)O)_n-H$ (PM: environ 500, 1000 ou 2000)
$HO-(CH_2CH_2O)_n-(CH_2CH(CH_3)O)_m-H$ (PM: environ 500, 1000 ou 2000)
$CH_2=C(CH_3)COO(CH_2CH_2O)_n-CH_3$ (n = 9, 14 ou 23)
$CH_2=CHCOO(CH_2CH_2O)_n-CH_3$ (n = 9, 14 ou 23)
$CH_2=CHCOOCH_2CH_2OCOCH_2CH_2COOH$
$CH_2=CHCOO(CH_2CH_2O)_n-COCH=CH_2$ (n = 9, 14 ou 23)
$CH_2=C(CH_3)COO(CH_2CH_2O)_n-COC(CH_3)=CH_2$ (n = 9, 14 ou 23)
$CH_2=CHCOO(CH_2CH(CH_3)O)_n-COCH=CH_2$ (n = 18 ou 23)
$CH_2=CHCOO(CH_2CH_2O)_n-(CH_2CH(CH_3)O)_m-COCH=CH_2$ (m + n = 18, 25 ou 30)
$CH_2=C(CH_3)COO(CH_2CH_2O)_n-COCH=CH_2$ (n = 18, 28 ou 36)

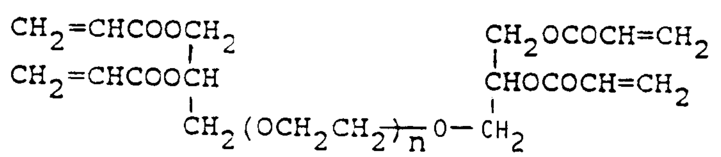

(n = 18, 23 ou 30)

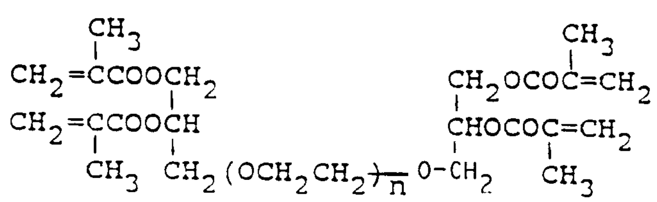

(n = 18, 23, ou 30)

4. Plaque présensibilisée sèche selon l'une quelconque des revendications précédentes, dans laquelle le polymère insoluble dans l'eau est choisi parmi les composés filmogènes ayant un poids moléculaire de 5 000 à 1000 000.

5. Plaque présensibilisée sèche selon l'une quelconque des revendications précédentes, dans laquelle le polymère insoluble dans l'eau est choisi parmi les résines de polyesters, les copolymères chlorure de vinyle-acétate de vinyle, les résines acryliques, les résines de chlorure de vinyle, les résines de polyamides, les résines époxy, les copolymères de (méth)acrylates, les résines de polyuréthanes et les résines d'acétate de vinyle.

6. Plaque présensibilisée sèche selon l'une quelconque des revendications précédentes, dans laquelle la

couche photosensible contient un ou plusieurs monomères et oligomères hydrophobes ayant des groupes éthyléniques polymérisables en quantité de 5 à 80% en poids par rapport au poids total de la composition photosensible.

**7.** Plaque présensibilisée sèche selon l'une quelconque des revendications précédentes, dans laquelle le rapport pondéral du composé soluble dans l'eau aux monomères ou oligomères hydrophobes est dans l'intervalle de 1:10 à 10:1.

**8.** Plaque présensibilisée sèche selon l'une quelconque des revendications précédentes, dans laquelle le polymère insoluble dans l'eau est présent en quantité de 10 à 90% en poids par rapport au poids total de la composition photosensible.

**9.** Plaque présensibilisée sèche selon l'une quelconque des revendications précédentes, qui contient en outre une couche première entre le support et la couche photosensible.

**10.** Utilisation de la plaque présensibilisée sèche selon l'une quelconque des revendications 1 à 9 dans la préparation d'une plaque d'impression lithographique ne nécessitant pas d'humidification par l'eau.